# FASCICULE DE BREVET EUROPEEN

(11) **EP 1 423 873 B1**
(45) Date de publication et mention de la délivrance du brevet: **08.03.2006**
(21) Numéro de dépôt: 02794814.0
(22) Date de dépôt: 14.08.2002
(51) Int. Cl.: H01L 21/762

(54) **PROCEDE D'OBTENTION D'UNE COUCHE MINCE AUTO-PORTEE D'UN MATERIAU SEMI-CONDUCTEUR SUPPORTANT AU MOINS UN COMPOSANT ET/OU CIRCUIT ELECTRONIQUE**
VERFAHREN ZUM ERHALTEN EINES SELBSTTRAGENDEN HALBLEITERDÜNNFILMS FÜR ELEKTRONISCHE SCHALTUNGEN
METHOD FOR OBTAINING A SELF-SUPPORTED SEMICONDUCTOR THIN FILM FOR ELECTRONIC CIRCUITS

(30) Priorité: 14.08.2001 FR 0110813
(43) Date de publication de la demande: 02.06.2004
(73) Titulaire: S.O.I.Tec Silicon on Insulator Technologies, 38190 Bernin (FR)
(72) Inventeur: RAYSSAC, Olivier, F-38000 Grenoble (FR); MAZURE, Carlos, F-38330 Saint-Nazaire les Eymes (FR); GHYSELEN, Bruno, F-38170 Seyssinet-Pariset (FR)
(74) Mandataire: Bomer, Françoise Marie
(86) Numéro de dépôt international: PCT/FR2002/002879
(87) Numéro de publication internationale: WO 2003/017357

(56) Documents cités:
- FR-A- 2 681 472
- FR-A- 2 789 518
- US-B1- 6 191 007

## Description

La présente invention concerne un procédé d'obtention d'une couche mince auto-portée d'un matériau semi-conducteur, supportant ou destiné à supporter au moins un composant et/ou circuit électronique.

Dans certains domaines de l'électronique, de l'optique, de l'optoélectronique ou des capteurs, les évolutions techniques poussent les constructeurs à fabriquer des couches minces munies de composants et de circuits électroniques, de plus en plus fines.

En particulier dans le domaine des cartes à puces, il est souhaitable que celles-ci soient de plus en plus fines et donc flexibles, car elles seront alors plus tolérantes à la déformation. En d'autres termes, à déformation constante, plus la couche mince est flexible et plus il devient possible de réaliser des circuits de grande dimension.

Dans certaines applications du type radio fréquence, un circuit intégré porté par la face avant d'une plaquette constituée d'un substrat de type silicium sur isolant (connu sous la marque déposée SOI) est couplé à une antenne, en vue d'obtenir la détection sans contact. A titre d'exemple, on peut citer un ticket de bus ou de métro permettant de valider le passage d'une personne, à distance d'une borne émettrice-réceptrice.

L'avantage de l'utilisation d'un substrat du type silicium sur isolant est que la puissance consommée par le composant déposé sur sa surface est largement plus faible que celle des composants réalisés sur une couche de silicium. A puissance égale, on obtient ainsi une augmentation de la distance de fonctionnement.

En couplant les avantages apportés par les composants réalisés sur un substrat silicium sur isolant, avec l'emploi de couches actives les plus fines possibles, il est possible d'obtenir un produit - par exemple un ticket - dont le champ d'action est accru et dont la résistance mécanique aux contraintes extérieures est très fortement améliorée.

Actuellement, l'épaisseur des couches minces avant "l'encartage", (c'est-à-dire la fixation de la puce sur la carte plastifiée lui servant de support) est de l'ordre d'une centaine de micromètres.

La technique utilisée pour obtenir cette gamme d'épaisseur consiste à effectuer une opération d'amincissement sur la face arrière d'un substrat, c'est-à-dire la face opposée à celle supportant les composants électroniques. Cet amincissement est réalisé par abrasion mécanique à l'aide d'une ponceuse (technique connue sous le terme anglais de "grinding") et/ou par attaque chimique à l'acide (dont l'une des techniques est connue sous le terme anglais de "spin-etching"). On obtient ainsi des couches minces d'une épaisseur comprise entre 80 et 120 µm. Cette technique permet de réaliser une production à fort volume.

Diverses tentatives ont déjà été faites pour obtenir des couches minces présentant une épaisseur finale inférieure à 100 µm. Toutefois, les fabriquants se sont heurtés à des problèmes de rendement, du fait du nombre élevé de pièces défectueuses obtenues, notamment du fait des ébréchures ou du clivage des plaques. Or, le domaine des cartes à puce est l'un des domaines de l'électronique pour lequel les coûts doivent être les plus bas possible, et de ce fait, des pertes de rendement de quelques pour-cent, voire même de quelques dixièmes de pour-cent ne peuvent être tolérées.

Cependant, compte tenu de l'évolution prévisible des cartes à puce dans les années à venir, il serait souhaitable d'obtenir des couches minces auto-portées ou plaquettes fines, d'une épaisseur voisine de 30 µm, et supportant des composants et/ou circuits électroniques.

On connaît déjà d'après l'art antérieur, des procédés permettant d'obtenir des couches auto-portées d'une épaisseur voisine de quelques dizaines de micromètres.

Ainsi, le document EP 0849788 décrit un procédé de fabrication d'un article semi-conducteur, selon lequel on rend poreuse la surface d'un substrat en silicium monocristallin, puis on fait croître par épitaxie, sur cette couche poreuse, une couche de silicium non poreux de l'épaisseur de la couche active désirée. On obtient ainsi une couche poreuse, donc fragilisée, enterrée entre deux couches de silicium non poreux. On peut ensuite traiter la couche superficielle active de silicium pour y déposer des couches supplémentaires, par exemple des couches dopées, puis on applique un film adhésif sur cet empilement de couches. Enfin, après arrachement de ce film adhésif et rupture de l'empilement de couches au niveau de la couche poreuse, puis élimination ultérieure du reste de cette couche poreuse, il devient possible de réaliser des composants électroniques sur la couche active de silicium qui peut être auto-portée.

Malheureusement, ce procédé se heurte à des problèmes liés à la qualité de la couche cristalline de silicium formée sur la couche poreuse et à la réalisation de la couche de silicium poreux. En effet, cette dernière nécessite des équipements non conventionnels et induit une possibilité de contamination métallique.

De plus, ce procédé nécessite la fabrication d'un substrat spécifique, avant de réaliser les composants électroniques, ce qui peut nécessiter de modifier de manière significative le procédé de réalisation des composants. Or, ceci n'est en général pas souhaitable pour des raisons de coût.

On connaît également des techniques d'obtention de couches minces, basées notamment sur le procédé connu sous la marque déposée "Smart-cut" bien connu de l'homme de métier.

Dans toutes ces techniques d'obtention de couches minces, on effectue l'implantation des espèces atomiques sur la face avant du substrat ou de la plaquette, c'est-à-dire la face portant, ou destinée à porter, les composants électroniques.

Ainsi, le document FR 2 ,747 506 divulgue un procédé d'implantation ionique générant des microbulles gazeuses sur la face avant du substrat, après la fabrication des composants électroniques.

Toutefois, l'implantation d'ions à travers les couches électriquement actives constituant les composants électroniques peut créer des défauts qui rendent ces composants inutilisables.

Le document FR 2 758 907 prétend résoudre ce problème en utilisant un masquage des zones actives sensibles et en réalisant ainsi une couche fragilisée discontinue. Toutefois, ce procédé reste délicat à mettre en oeuvre.

Enfin, le document FR 2 748 851 offre une autre solution au problème précité du dysfonctionnement des composants électroniques. Le procédé qu'il divulgue consiste à réaliser l'implantation ionique sur la face avant d'un substrat, antérieurement à la fabrication des composants électroniques sur cette même face, puis à effectuer seulement ultérieurement la séparation de la couche mince.

Ce procédé nécessite toutefois la réalisation d'un substrat spécifique avant de réaliser les composants électroniques, ce qui peut nécessiter de modifier de manière significative le procédé de fabrication de ces composants. Ceci n'est en général pas souhaitable pour des raisons de coût.

L'invention a pour but de résoudre les problèmes précités et de permettre l'obtention d'une couche auto-portée portant des composants et/ou des circuits électroniques, c'est à dire une couche dont l'epaisseur est de l'ordre de 30 µm.

A cet effet, l'invention concerne un procédé selon la revendication 1.

Grâce à ces caractéristiques de l'invention, il devient possible d'obtenir des couches minces avec des rendements élevés difficilement susceptibles d'être obtenus par les techniques de l'art antérieur et sans avoir à modifier le procédé de fabrication des composants électroniques ou à réaliser une plaquette spécifique comme cela était souvent le cas dans l'art antérieur.

Selon d'autres caractéristiques avantageuses mais non limitatives de l'invention, prises seules ou en combinaison :
- le procédé consiste avant la toute première étape a) d'implantation, à amincir ladite plaquette par un procédé d'amincissement mécanique et/ou chimique réalisé sur sa face arrière ;
- il consiste à réaliser au moins un composant et/ou circuit électronique sur la face avant de ladite plaquette, avant toute première étape d'implantation ;
- l'étape de détachement de la partie arrière est effectuée par application d'un traitement thermique et/ou de contraintes mécaniques extérieures ;
- l'étape de détachement de la partie arrière est effectuée par soufflage d'un jet de fluide ;
- l'étape de détachement de la partie arrière est effectuée par brossage ;
- l'étape de détachement de la partie arrière est effectuée par application d'un raidisseur sur la face arrière de ladite plaquette, puis application d'un traitement thermique et/ou de contraintes mécaniques extérieures sur ce raidisseur ;
- le raidisseur est appliqué par dépôt;
- le raidisseur est une couche d'oxyde de silicium ;
- le raidisseur est une plaque rigide ;
- la plaque rigide est en silicium monocristallin ou polycristallin ou en verre ;
- le raidisseur est un film souple ;
- le raidisseur est un film adhésif ;
- le raidisseur est une couche de cire ;
- avant l'étape de détachement de la partie arrière, on applique un raidisseur sur la face avant de ladite plaquette et on retire ce raidisseur après avoir obtenu la couche mince auto-portée ;
- la plaquette est en silicium ;
- la plaquette est une plaquette de silicium sur isolant ;
- la plaquette est réalisée dans un matériau choisi parmi le germanium, un alliage de silicium et de germanium (Si-Ge), le carbure de silicium, l'arséniure de gallium, le phosphure d'indium (InP), le nitrure de gallium (GaN) ou le nitrure d'aluminium (AIN).

D'autres caractéristiques et avantages de l'invention apparaîtront à la lecture de la description suivante de trois modes de réalisation préférés de l'invention, donnés à titre d'exemples illustratifs mais non limitatifs. Cette description est établie en faisant référence aux dessins joints dans lesquels :
- les figures 1 à 6 sont des schémas illustrant les différentes étapes successives d'un premier mode de réalisation du procédé selon l'invention ;
- les figures 7 à 12 sont des schémas illustrant les différentes étapes successives d'un deuxième mode de réalisation du procédé selon l'invention, et
- les figures 13 à 17 sont des schémas illustrant les étapes successives d'un troisième mode de réalisation du procédé selon l'invention ;
- les figures 18 à 21 sont des schémas illustrant les étapes successives d'une variante de réalisation de procédé.

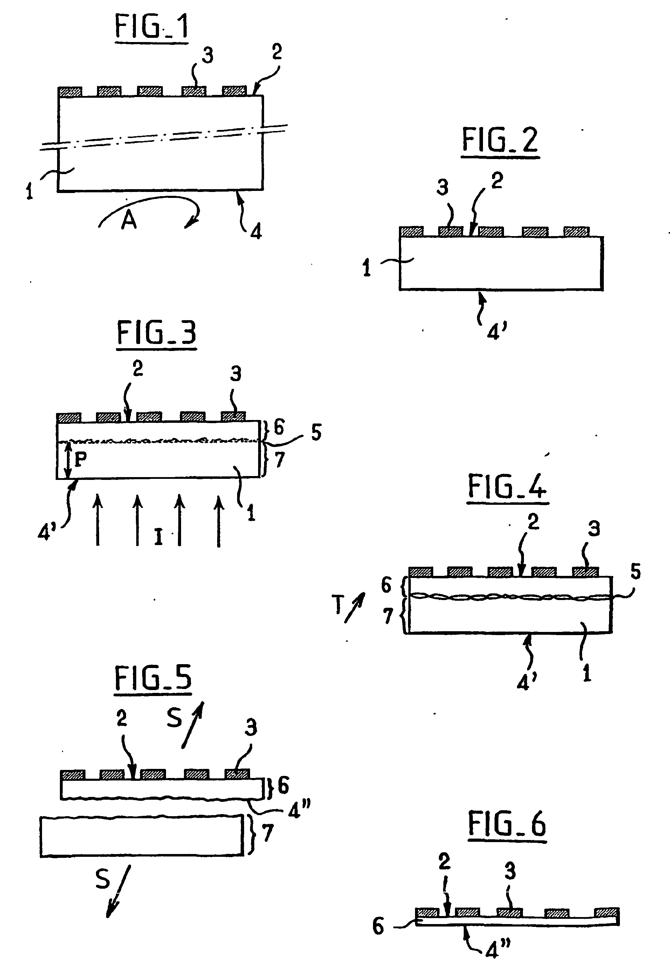

On notera que dans les trois modes de réalisation du procédé selon l'invention qui sont décrits, les deux premières étapes (illustrées respectivement sur les figures 1 et 2 pour le premier mode, 7 et 8 pour le deuxième mode et 13 et 14 pour le troisième mode) sont identiques. En conséquence, elles ne seront décrites en détail que pour le premier mode de réalisation.

La figure 1 illustre une plaquette 1 présentant une première face plane 2, dite "face avant", supportant -ou destinée à supporter- au moins un composant et/ou circuit électronique 3 et une deuxième face plane opposée 4, dite "face arrière".

Par composant et/ou circuit électronique, on entend toute structure ou élément de structure, réalisée de manière complète ou partielle, élaborée dans le but de réaliser des composants, circuits et dispositifs dans les domaines de l'électronique, de l'optique, de l'opto-électronique ou des capteurs, et de manière plus générale dans les domaines d'applications liées aux semi-conducteurs.

L'expression "supportant - ou destinée à supporter - au moins un composant et/ou un circuit électronique" signifie que lesdits composant(s) et/ou circuit(s) soit sont déjà réalisés sur la face avant 2 de ladite plaquette 1 avant de commencer les étapes du procédé selon l'invention, soit seront réalisés ultérieurement, mais toutefois sur ladite face avant 2, alors que toutes les autres étapes du procédé selon l'invention seront réalisées sur la face opposée, dite "face arrière".

A des fins de simplification, dans la suite de la description, (et comme représenté sur les figures), on a choisi de décrire le cas où les composants et/ou circuits 3 ont été réalisés sur la plaquette 1 avant le déroulement des diverses étapes d'amincissement du procédé selon l'invention.

On notera que dans les procédés de l'art antérieur où les composants 3 sont réalisés après l'amincissement, ce dernier a été réalisé sur la face avant 2.

La plaquette 1 est réalisée dans un matériau semi-conducteur, celui-ci pouvant être monocristallin, polycristallin ou amorphe, notamment un matériau à base de silicium.

Ce silicium peut être massif ou être obtenu par épitaxie sur un substrat.

Cette plaquette 1 peut également être une plaquette de "silicium sur isolant", c'est à dire comprenant une fine couche d'isolant (par exemple d`oxyde de silicium), insérée entre une couche de silicium actif sur laquelle est gravée le circuit électronique et un substrat servant de support mécanique. Une telle plaquette est connue sous l'acronyme "SOI".

Selon une variante, cette plaquette 1 peut également être réalisée dans un matériau choisi parmi le germanium, un alliage de silicium et de germanium (Si-Ge), le carbure de silicium, l'arséniure de gallium, le phosphate d'indium (InP), le nitrure de gallium (GaN) ou le nitrure d'aluminium (AIN).

Cette plaquette 1 présente une épaisseur de plusieurs centaines de micromètres, (à titre d'exemple, une plaquette de silicium de 200 mm de diamètre présente une épaisseur d'environ 725 µm). En conséquence, cette plaquette 1 n'est pas représentée à l'échelle sur la figure 1.

La face arrière 4 de cette plaquette 1 est ensuite amincie par l'un des procédés classiques précités, c'est-à-dire par abrasion mécanique et/ou attaque chimique à l'acide, comme symbolisé par la flèche A. On pourrait également utiliser l'amincissement par gravure plasma. La face arrière 4 est celle ne portant pas de composants électroniques.

On obtient ainsi la plaquette amincie illustrée en figure 2 d'une épaisseur comprise entre 80 et 120 µm, voire même 50 µm.

La face arrière de cette plaquette amincie porte la référence 4'.

Cette étape est avantageuse en ce qu'elle permet d'enlever une grande quantité de matière à faible coût selon une technique bien connue de l'homme du métier et couramment employée. Toutefois, elle ne peut être poursuivie jusqu'à l'obtention de la couche mince de l'épaisseur désirée, car comme expliqué précédemment, on aboutit alors à une forte diminution de rendement.

En effet, la poursuite de ce procédé au delà des épaisseurs précitées de 50 µm augmente fortement le risque de rupture ou d'ébréchures des plaquettes.

Par ailleurs, l'épaisseur obtenue, notamment après une attaque chimique n'est plus homogène.

De plus, l'amincissement mécanique par ponçage laisse une zone superficielle de quelques microns d'épaisseur légèrement endommagée. Or lorsque l'on s'approche de l'épaisseur finale désirée, ceci n'est pas acceptable.

Enfin, après une attaque chimique, la plaquette est généralement attaquée plus fortement à sa périphérie qu'en son centre. Lorsque l'on atteint de faibles épaisseurs, il s'en suit une diminution de diamètre et donc une diminution de la surface susceptible d'être occupée par les composants.

On notera toutefois que cette première étape d'amincissement mécanique et/ou chimique bien qu'avantageuse d'un point de vue économique est facultative et que l'étape suivante d'implantation d'espèces atomiques pourrait être réalisée directement sur la face arrière 4 de la plaquette 1 non amincie.

La troisième étape du procédé illustrée sur la figure 3 consiste à implanter des espèces atomiques (flèches I) à l'intérieur de ladite plaquette 1, de façon à obtenir une zone de fragilisation 5 ou zone d'apparition de défauts, à une profondeur voisine de la profondeur moyenne d'implantation P desdites espèces atomiques.

Selon une caractéristique fondamentale de l'invention, cette implantation est effectuée depuis la face arrière 4' (ou 4 si la plaquette n'a pas été amincie au préalable).

Par implantation d'espèces atomiques, on entend tout bombardement d'espèces atomiques, moléculaires ou ioniques, susceptible d'introduire ces espèces dans un matériau, avec un maximum de concentration de ces espèces dans ce matériau, ce maximum étant situé à une profondeur déterminée par rapport à la surface bombardée. Les espèces atomiques moléculaires ou ioniques sont introduites dans le matériau avec une énergie également distribuée autour d'un maximum.

L'implantation des espèces atomiques dans le matériau peut être réalisée par exemple grâce à un implanteur par faisceau d'ions ou un implanteur par immersion dans un plasma.

De préférence, cette implantation est réalisée par bombardement ionique. Celui-ci consiste en une étape d'implantation ionique au cours de laquelle la face arrière de la plaquette 1 est bombardée par des espèces atomiques. De préférence, celle-ci sont choisies parmi les ions de gaz rares (du type hélium, néon, krypton, xénon) et de gaz hydrogène, pris isolément ou en combinaison, afin de créer dans le volume du substrat et à une profondeur moyenne de pénétration des ions, une zone de fragilisation 5.

De préférence toutefois, les espèces atomiques implantées consistent en de l'hydrogène uniquement.

La zone de fragilisation 5 ainsi formée délimite une partie avant 6 correspondant à la partie supérieure de la plaquette 1 et s'étendant de la face avant 2 supportant les composants 3 jusqu'à ladite zone de fragilisation 5 et une partie arrière 7 formée du reste de ladite plaquette 1.

L'énergie des espèces atomiques implantées permet de déterminer la profondeur moyenne P d'implantation de ces espèces, calculée depuis la surface de la face arrière 4', tandis que la dose moyenne implantée permet de déterminer la quantité de défauts de structure formés à cette profondeur P. L'homme du métier ajustera ces deux paramètres en conséquence. L'expression profondeur moyenne P signifie que celle-ci ne présente pas une valeur unique, mais peut présenter plusieurs valeurs voisines.

Dans le mode de réalisation illustré sur la figure 3, on utilise une implantation à haute énergie, c'est-à-dire effectuée à environ 1 MeV.

A titre d'exemple illustratif, avec une telle énergie d'implantation et en implantant de l'hydrogène monoatomique dans une plaquette de silicium selon une dose appropriée (de l'ordre de 10¹⁷ atomes d'hydrogène, par exemple), il est possible d'obtenir une profondeur d'implantation de 15 µm environ.

Des équipements permettant d'obtenir une telle énergie d'implantation existent actuellement. Au Japon par exemple, le *Japan Atomic Energy Research Institute* (JAERI) a développé et utilise un implanteur hydrogène dans des gammes d'énergie de 1 MeV avec la spécificité de retenir un état de charge -1 pour les ions Hydrogène (ions H-). Pour le cas de l'Hélium, le document WO 00/61 841 par exemple, utilise une énergie d'implantation de 3,8 MeV.

Les étapes suivantes du procédé, illustrées sur les figures 4 et 5 consistent à effectuer le détachement de la partie arrière 7 de la plaquette 1.

Dans le cas présent, cette partie arrière 7 est d'une épaisseur suffisante pour se présenter sous la forme d'une couche monobloc, c'est à dire formant un tout.

Son détachement de la partie avant 6 est alors réalisé par application d'un traitement thermique et/ou par application de contraintes mécaniques extérieures.

Plus précisément, ce détachement peut s'effectuer soit uniquement sous l'action de l'apport d'un budget thermique approprié, par chauffage de la plaquette 1 à une température suffisante pour provoquer un détachement (flèches S, voir figure 6) des deux parties 6 et 7 de la plaquette, soit uniquement par application de contraintes mécaniques extérieures, sans traitement thermique.

Selon une variante, ce détachement peut également être effectué avec l'aide d'une contrainte mécanique extérieure, appliquée pendant ou après l'étape de traitement thermique.

L'application d'une contrainte mécanique peut consister à exercer une flexion et/ou une traction ou un cisaillement sur les deux parties 6 et 7 ou à introduire entre elles une lame ou un jet de fluide (liquide ou gazeux) continu ou temporellement variable, au niveau de l'interface des couches à détacher.

Il peut également s'agir de l'application d'ultrasons.

Les contraintes mécaniques extérieures peuvent également avoir pour origine une énergie électrique (application d'un champ électrostatique ou électromagnétique).

Les contraintes ayant pour origine une énergie thermique peuvent dériver de l'application d'un champ électromagnétique, d'un faisceau d'électrons, d'un chauffage thermoélectrique, d'un fluide cryogénique, d'un liquide super-refroidi, etc.

La partie avant 6 ainsi obtenue constitue une couche mince d'une épaisseur d'environ 35 µm. Cette couche mince supporte les composants et/ou les circuits 3.

La face arrière 4" de cette couche mince peut dans certains cas être polie (voir figure 6) ou subir divers traitements de surface appropriés pour devenir absolument plane. Toutefois, la planéité n'est pas obligatoire puisqu'il s'agit justement de la face arrière.

La couche mince 6 ainsi obtenue est d'une épaisseur suffisante pour être auto-portée, elle peut ensuite être découpée et reportée puce par puce, sur une carte de support plastifiée, par exemple. La découpe en puce peut également avoir lieu avant l'amincissement.

Si l'épaisseur enlevée, c'est-à-dire l'épaisseur de la partie arrière 7 est insuffisante, les étapes d'implantation et de détachement illustrées sur les figures 3, 4 et 5 sont répétées sur la face arrière 4" de la partie avant 6 (ou couche mince 6), jusqu'à ce que celle-ci présente l'épaisseur désirée, c'est-à-dire une épaisseur voisine de 30 µm.

On notera qu'une implantation à très haute énergie, c'est à dire au-delà de 1 MeV (par exemple 5 MeV) pourrait permettre d'augmenter la profondeur P d'implantation des ions et d'enlever une épaisseur de matériau plus importante encore.

Grâce au procédé de l'invention, il est possible d'amincir la plaquette 1, sans détériorer les composants électroniques 3 lorsque ces derniers sont présents sur la face avant 2 avant l'implantation.

En outre, en connaissant l'épaisseur de la plaquette 1 d'origine et en choisissant de façon appropriée les paramètres d'implantation des espèces atomiques, il devient possible de réduire l'épaisseur de cette plaquette 1, en une ou plusieurs fois, par élimination d'une épaisseur déterminée, de façon à aboutir, de façon relativement précise, à l'épaisseur finale souhaitée pour la couche 6.

Le procédé conforme à l'invention permet d'utiliser au mieux les appareils d'implantation. On commencera généralement l'amincissement en implantant à forte énergie pour enlever une partie arrière 7 d'épaisseur importante, puis on affinera en implantant à plus faible énergie pour enlever une épaisseur moindre.

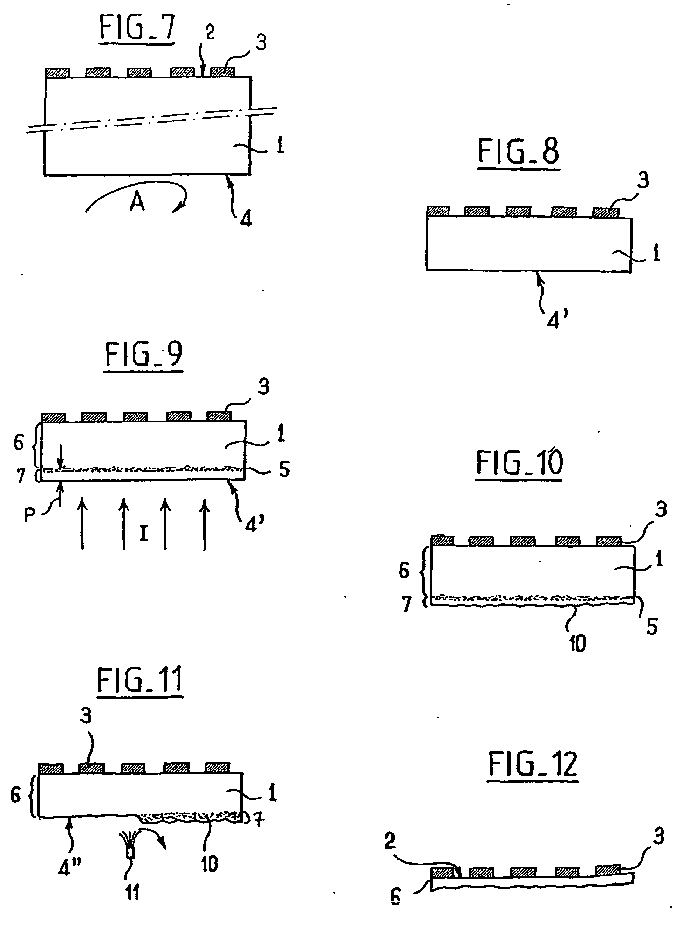

Un deuxième mode de réalisation du procédé selon l'invention est illustré sur les figures 7 à 12.

La figure 9 illustre l'étape d'implantation des espèces atomiques effectuée sur la face arrière 4' de la plaquette amincie, (voire même directement sur la face arrière 4 de la plaquette 1 non amincie au préalable).

Dans ce cas, l'implantation est effectuée à l'aide des implanteurs couramment utilisés actuellement en micro-électronique. L'énergie d'implantation est faible, c'est-à-dire voisine de quelques centaines de KeV.

Pour l'implantation, on se reportera à ce qui a été décrit précédemment pour le premier mode de réalisation.

A titre d'exemple, pour une implantation d'hydrogène monoatomique dans du silicium, à une énergie d'implantation de 210 KeV, avec une dose d'implantation comprise entre 2.10¹⁶ et 10¹⁷ atomes d'hydrogène monoatomique par cm², on peut réaliser une zone de fragilisation 5 à une profondeur d'implantation P d'environ 1,5 à 2 µm.

Les figures 10 et 11 illustrent l'étape de détachement de la partie arrière 7.

Dans cette gamme d'épaisseur d'implantation peu profonde, la partie arrière 7 n'exfolie pas ou seulement de façon partielle. Elle ne présente pas d'aspect homogène. Il se forme des cloques 10 et la partie arrière 7 se présente plutôt comme une pluralité de copeaux de matière (de miettes).

Comme illustré sur la figure 11, cette partie arrière 7 est alors détachée par exemple par brossage 11 ou par soufflage d'un jet de fluide, (par exemple un jet de liquide sous pression ou un jet de gaz, tel de l'air comprimé). Le brossage 11 utilisé est par exemple un brossage ("scrubber" selon l'équivalent anglo-saxon) tel que ceux utilisés couramment en micro-électronique en association avec des étapes de polissage mécano-chimique (CMP pour "chemical mechanical polishing" selon l'équivalent anglo-saxon). Par brossage, il faut aussi entendre toute autre technique équivalente connue de l'homme du métier permettant d'enlever des particules et autres copeaux de matière, tel qu'un polissage ou utilisation d'une raclette.

Les étapes d'implantation et de détachement de la partie arrière 7, illustrées sur les figures 9, 10 et 11 sont répétées sur la face arrière 4" de la partie avant 6 jusqu'à l'obtention de la couche mince auto-portée, représentée sur la figure 12.

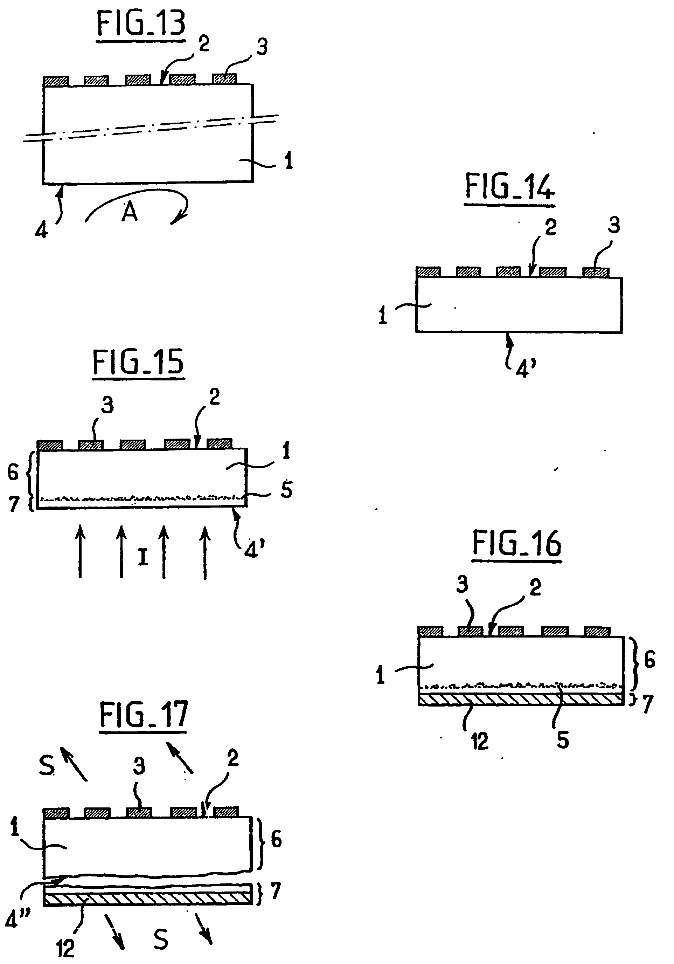

Les figures 13 à 17 illustrent un troisième mode de réalisation d procédé selon l'invention.

L'étape d'implantation d'espèces atomiques à basse énergie illustré sur la figure 15 est identique à ce qui vient d'être décrit pour la figure 9.

Après cette opération d'implantation, on applique sur la face arrière 4' de la plaquette amincie (ou la face arrière 4 de la plaquette non amincie), un raidisseur 12.

Par le terme "application", on entend aussi bien une application par dépôt, telle que par pulvérisation ou par dépôt chimique en phase vapeur (en anglais CVD pour "chemical vapor deposition"), qu'une application "physique" consistant à venir poser une plaque rigide ou un film souple sur ladite face avant 2. Ces techniques sont connues de l'homme du métier.

Dans le cas de la plaque rigide, il peut s'agir d'une plaque de verre ou de silicium mono ou polycristallin.

Dans le cas du film souple, il peut s'agir d'un film de matière plastique ou de polytétrafluoroéthylène connu sous la marque déposée "Teflon", ou d'un ruban adhésif.

Le raidisseur peut également être une couche de cire.

Dans le cas d'un dépôt, il s'agira avantageusement d'une couche d'oxyde de silicium (SiO2) par exemple.

Lorsque le raidisseur 12 est une plaque rigide ou un film souple, il peut être collé par adhésion moléculaire ou par collage eutectique, Dans ce cas, la surface arrière du substrat doit présenter un bon état de surface ou être polie.

Ce raidisseur 12 peut également être collé par un adhésif

Il est ensuite retiré (voir figure 17) par application de contraintes mécaniques (flèches S) ou lorsqu'il est collé par un traitement thermique permettant d'éliminer la colle le liant à la plaquette 1 ou par un traitement chimique, connu sous la terminologie anglaise de "lift-off" (dissolution de la colle par action d'un solvant approprié).

Les opérations illustrées sur les figures 15, 16 et 17 peuvent être répétées plusieurs fois sur la face arrière 4" de la partie avant 6 (ou couche mince 6), jusqu'à ce que celle-ci présente l'épaisseur désirée (étape illustrée sur les figures 6 ou 12).

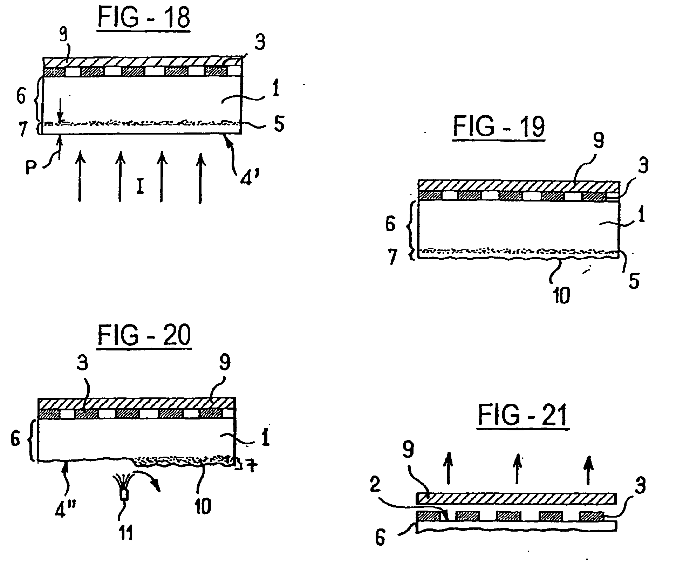

Enfin, les figures 18 à 21 illustrent une variante de réalisation du procédé de l'invention, selon laquelle on applique un raidisseur 9 sur la face avant 2 de la plaquette 1, soit avant l'étape d'implantation d'espèces atomiques (voir figure 18), soit immédiatement après cette étape (voir figure 19), de façon que ce raidisseur 9 soit présent au moment du détachement de la partie arrière 7.

Ce qui a été décrit au sujet de la nature et de l'application du raidisseur 12 s'applique également au raidisseur 9 et ce dernier ne sera pas décrit davantage.

Ce raidisseur 9 a uniquement comme fonction de faciliter temporairement la manipulation de la partie avant 6 obtenue, notamment lorsque l'on répète plusieurs fois les opérations d'amincissement par la face arrière.

Une fois, la couche auto-portée 6 d'épaisseur voulue obtenue, ce raidisseur 9 pourra être enlevé par un traitement approprié, au cours de la dernière étape du procédé (voir figure 21). Il peut éventuellement être enlevé après la découpe et l'encartage de la couche 6.

Le procédé d'amincissement qui vient d'être décrit, (quel que soit le mode de réalisation choisi), présente l'avantage d'être réalisé sur des plaquettes standards, couramment utilisées en micro-électronique, sur lesquelles les composants et/ou les circuits électroniques sont disposés à l'aide d'équipements courants. Il n'est donc absolument pas nécessaire de modifier ces étapes préalables de réalisation de la plaquette avant d'effectuer le procédé selon l'invention.

D'une manière plus générale, ce procédé s'applique à tout substrat portant ou destiné à porter des composants électroniques sur sa face avant.

On donnera ci-après sept exemples de réalisation particuliers du procédé selon l'invention.

### Exemple 1 :

Une plaquette de silicium monocristallin 1 d'un diamètre de 200 mm et d'une épaisseur de 725 µm, dont la face avant 2 supporte des composants et/ou des circuits électroniques 3, est soumise à une première étape d'amincissement mécanique et/ou chimique. On obtient ainsi une plaquette amincie d'une épaisseur de 50 µm.

On effectue alors sur la face arrière 4' de cette plaquette amincie, une étape d'implantation d'ions H⁺, à une énergie de 1 MeV, selon une dose d'implantation de 1,8.10¹⁷ H⁺/cm². Cette implantation est réalisée à température ambiante. La profondeur moyenne d'implantation P est de 15 µm.

On applique ensuite une contrainte thermique à la plaquette, par chauffage à 400° C ce qui permet de procéder à l'exfoliation de la partie arrière 7 d'une épaisseur d'environ 15 µm.

La couche mince 6 obtenue présente une épaisseur de 35 µm.

### Exemple 2 :

On procède de façon identique à ce qui vient d'être décrit pour l'exemple 1, sauf que le traitement thermique est effectué à 350°C et que l'on procède au retrait de la partie arrière 7 se présentant sous forme d'un film monobloc continu par arrachement à l'aide d'un ruban adhésif (raidisseur temporaire).

La couche mince 6 obtenue présente une épaisseur de 35 µm.

### Exemple 3 :

Les étapes d'amincissement préalable et d'implantation sont identiques à ce qui a été décrit pour l'exemple 2, sauf qu'avant la première étape d'amincissement mécanique et/ou chimique, on dépose un raidisseur 9 sur la face avant 2 de la plaquette. Ce raidisseur 9 étant une plaque de silicium collée par une couche d'oxyde de 5 µm d'épaisseur, planarisé avant le collage, ce collage étant effectué par collage direct (connu sous l'expression anglo-saxonne de "wafer bonding".

La couche mince 6 obtenue présente une épaisseur de 35 µm.

### Exemple 4 :

Cet exemple reprend l'exemple 1 si ce n'est que l'épaisseur de la plaquette 1 après l'amincissement mécanique et/ou chimique est de 35 µm, que l'implantation est une implantation plasma, que l'énergie d'implantation est de 200 keV, que la profondeur moyenne d'implantation P est de 2 µm, que la dose d'implantation est de 1.10¹⁷ H⁺/cm² et que le traitement thermique est effectué à 400°C.

On procède ensuite au brossage pour retirer la partie arrière 7.

La partie avant 6 obtenue présente une épaisseur de 33 µm.

Ce cycle d'opération est répété encore une fois, jusqu'à obtenir une couche mince 6 d'une épaisseur finale de 31 µm.

### Exemple 5 :

Les étapes d'amincissement préalable et d'implantation sont identiques à ce qui a été décrit pour l'exemple 1, sauf que l'épaisseur de la plaquette 1 après l'amincissement mécanique et/ou chimique est de 35 µm, que l'énergie d'implantation est de 200 keV, que la profondeur moyenne d'implantation P est de 2 µm et que la dose d'implantation est de 1.10¹⁷ H⁺/cm².

Avant l'implantation, on procède au collage d'un raidisseur temporaire 9 constitué d'une plaque de verre sur la face avant 2. Le collage étant effectué à l'aide d'une colle réversible sous les U.V.

Après détachement de la partie arrière 7, la partie avant 6 obtenue présente une épaisseur de 33 µm.

Ce cycle d'opération est répété deux fois, jusqu'à obtenir une couche mince 6 d'une épaisseur finale de 29 µm après enlèvement du raidisseur 9 avec, si nécessaire, le renouvellement du raidisseur 9 sur la face avant 2 entre chaque cycle.

### Exemple 6 :

Les étapes d'amincissement préalable et d'implantation sont identiques à ce qui a été décrit pour l'exemple 1, sauf que l'épaisseur de la plaquette 1 après l'amincissement mécanique et/ou chimique est de 40 µm, que l'énergie d'implantation est de 750 keV, que la profondeur moyenne d'implantation P est de 10 µm et que la dose d'implantation est de 1,3.10¹⁷ H⁺/cm².

En outre, avant l'étape d'implantation, on procède au collage d'un raidisseur 9 constitué d'une plaque de verre sur la face avant 2. Le collage étant effectué à l'aide d'une colle réversible sous les U.V.

Après l'implantation, on procède au collage d'un raidisseur 12 constitué d'une plaque de verre sur la face arrière. Le collage est effectué à l'aide d'une colle réversible sous les U.V.

On procède alors à l'arrachement mécanique de la partie arrière 7 par introduction entre les deux plaques de verre, au niveau de la zone de fragilisation 5, d'une lame ou d'un jet d'air ou d'eau comprimé.

La couche auto-portée 6 obtenue présente une épaisseur de 30 µm.

### Exemple 7 :

Une plaquette de silicium monocristallin 1 d'un diamètre de 200 mm et d'une épaisseur de 725 µm, dont la face avant 2 supporte des composants et/ou des circuits électroniques 3, est soumise à une première étape d'amincissement mécanique et/ou chimique. On obtient ainsi une plaquette amincie d'une épaisseur de 40 µm.

On effectue alors sur la face arrière 4', une étape d'implantation ionique d'ions H⁺, à une énergie de 750 keV, selon une dose d'implantation de 1,3.10¹⁷ H⁺/cm². Cette implantation est réalisée à température ambiante. La profondeur moyenne d'implantation P est de 10 µm.

Avant la première étape d'amincissement mécanique et/ou chimique, on dépose un raidisseur 9 sur la face avant 2 de la plaquette. Ce raidisseur 9 est une plaque de silicium collée par une couche d'oxyde de 5 µm d'épaisseur, planarisé avant le collage, ce collage étant effectué par collage direct (connu sous l'expression anglo-saxonne de "wafer bonding"). Ce raidisseur reste en place jusqu'à la fin du procédé et sera enlevé lorsque l'on aura obtenu la couche 6 de l'épaisseur désirée.

On applique ensuite une contrainte thermique à la plaquette, par chauffage à 400° C puis brossage, ce qui permet de procéder à l'exfoliation de la partie arrière 7.

La partie avant 6 obtenue présente une épaisseur de 30 µm et constitue une couche auto-portée.

Dans les exemples de mise en oeuvre décrits ci-dessus, la plaquette 1 est en silicium.

Toutefois, elle pourrait également être réalisée dans un matériau choisi parmi le germanium, un alliage de silicium et de germanium (SiGe), le carbure de silicium, l'arséniure de gallium, le phosphure d'indium, le nitrure de gallium ou le nitrure d'aluminium. La plaquette 1 pourrait également être un substrat de type SOI (de l'anglais Silicon On Insulator).

## Revendications

1. Procédé d'amincissement d'une plaquette (1) en matériau semi-conducteur présentant une première face (2), dite "face avant", supportant ou destinée à supporter - au moins un composant et/ou circuit électronique (3) et une deuxième face opposée (4), dite "face arrière", **caractérisé en ce qu'**il comprend les étapes consistant à :
a) implanter des espèces atomiques à l'intérieur de ladite plaquette (1), depuis sa face arrière (4, 4'), de façon à obtenir une zone de fragilisation (5) délimitant une partie avant (6) s'étendant de ladite face avant (2) à ladite zone de fragilisation (5) et une partie arrière (7) formée du reste de la plaquette (1),
b) retirer ladite partie arrière (7) de ladite partie avant (6), pour amincir la plaquette (1),
c) répéter, les étapes a) et b) sur la face arrière (4") de ladite partie avant (6), jusqu'à ce que celle-ci présente l'épaisseur désirée pour constituer une couche mince (6) auto-portée.

2. Procédé d'amincissement d'une plaquette (1) selon la revendication 1, **caractérisé en ce qu'**il consiste avant la toute première étape a) d'implantation, à amincir ladite plaquette (1) par un procédé d'amincissement mécanique et/ou chimique réalisé sur sa face arrière (4).

3. Procédé d'amincissement d'une plaquette (1) selon la revendication 1 ou 2, **caractérisé en ce qu'**il consiste à réaliser au moins un composant et/ou circuit électronique (3) sur la face avant (2) de ladite plaquette (1), avant la toute première étape a) d'implantation.

4. Procédé d'amincissement d'une plaquette (1) selon l'une quelconque des revendications précédentes, **caractérisé en ce que** l'étape de retrait de la partie arrière (7) est effectuée par application d'un traitement thermique et/ou de contraintes mécaniques extérieures.

5. Procédé d'amincissement d'une plaquette (1) selon l'une quelconque des revendications précédentes, **caractérisé en ce que** l'étape de retrait de la partie arrière (7) est effectuée par soudage d'un jet de fluide.

6. Procédé d'amincissement d'une plaquette (1) selon l'une quelconque des revendications précédentes, **caractérisé en ce que** l'étape de retrait de la partie arrière (7) est effectuée par brossage (11).

7. Procédé d'amincissement d'une plaquette (1) selon l'une quelconques des revendications précédentes, **caractérisé en ce que** l'étape de retrait de la partie arrière (7) est effectuée par application d'un raidisseur (12) sur la face arrière (4, 4', 4") de ladite plaquette (1), puis application d'un traitement thermique et/ou de contraintes mécaniques extérieures sur ce raidisseur (12).

8. Procédé d'amincissement d'une plaquette (1) selon la revendication 7, **caractérisé en ce que** le raidisseur (12) est appliqué par dépôt.

9. Procédé d'amincissement d'une plaquette (1) selon la revendication 8, **caractérisé en ce que** le raidisseur (12) est une couche d'oxyde de silicium.

10. Procédé d'amincissement d'une plaquette (1) selon la revendication 7, **caractérisé en ce que** le raidisseur (12) est une plaque rigide.

11. Procédé d'amincissement d'une plaquette (1) selon la revendication 10, **caractérisé en ce que** la plaque rigide (12) est en silicium monocristallin ou polycristallin ou en verre.

12. Procédé d'amincissement d'une plaquette (1) selon la revendication 7, **caractérisé en ce que** le raidisseur (12) est un film souple.

13. Procédé d'amincissement d'une plaquette (1) selon la revendication 7, **caractérisé en ce que** le raidisseur (12) est un film adhésif.

14. Procédé d'amincissement d'une plaquette (1) selon la revendication 7, **caractérisé en ce que** le raidisseur (12) est une couche de cire.

15. Procédé d'amincissement d'une plaquette (1) selon l'une quelconques des revendications précédentes, **caractérisé en ce qu'**avant l'étape de retrait de la partie arrière (7), on applique un raidisseur (9) sur la face avant (2) de ladite plaquette (1) et **en ce que** l'on retire ce raidisseur (9) après avoir obtenu la couche mince (6) auto-portée.

16. Procédé d'amincissement d'une plaquette (1) selon l'une quelconques des revendications précédentes, **caractérisé en ce que** ladite plaquette (1) est en silicium.

17. Procédé d'amincissement d'une plaquette (1) selon l'une quelconque des revendications 1 à 15, **caractérisé en ce que** ladite plaquette (1) est une plaquette de silicium sur isolant.

18. Procédé d'amincissement d'une plaquette (1) selon l'une quelconque des revendications 1 à 15, **caractérisé en ce que** ladite plaquette (1) est réalisée dans un matériau choisi parmi le germanium, un alliage de silicium et de germanium (Si-Ge), le carbure de silicium, l'arséniure de gallium, le phosphate d'indium, le nitrure de gallium ou le nitrure d'aluminium.

## Claims

1. A method of thinning a wafer (1) made of semiconductor material, the wafer having a first face (2) termed the "front face" supporting - or for supporting - at least one electronic component and/or circuit (3) and an opposing face (4), termed the "rear face", **characterized in that** it comprises steps consisting in:
a) implanting atomic species in the interior of said wafer (1), from its rear face (4, 4') to obtain a zone of weakness (5) defining a front portion (6) extending from said front face (2) to said zone of weakness (5) and a rear portion (7) formed by the remainder of the wafer (1);
b) removing said rear portion (7) from said front portion (6), to thin the wafer (1); and
c) repeating steps a) and b) on the rear face (4") of said front portion (6) until said front portion has the desired thickness for constituting a self-supported thin layer (6).

2. A method of thinning a wafer (1) according to claim 1, **characterized in that** prior to any first implantation step a), it consists in thinning said wafer (1) by a mechanical and/or chemical thinning method carried out on the rear face (4).

3. A method of thinning a wafer (1) according to claim 1 or claim 2, **characterized in that** it consists in producing at least one electronic component and/or circuit (3) on the front face (2) of said wafer (1), prior to any first implantation step.

4. A method of thinning a wafer (1) according to any preceding claim, **characterized in that** the step of removing the rear portion (7) is carried out by applying a heat treatment and/or applying external mechanical stresses.

5. A method of thinning a wafer (1) according to any preceding claim, **characterized in that** the step of removing the rear portion (7) is carried out by blowing a jet of fluid.

6. A method of thinning a wafer (1) according to any preceding claim, **characterized in that** the step of removing the rear portion (7) is carried out by scrubbing (11).

7. A method of thinning a wafer (1) according to any preceding claim, **characterized in that** the step of removing the rear portion (7) is carried out by applying a stiffener (12) to the rear face (4, 4', 4") of said wafer (1), then applying a heat treatment and/or external mechanical stresses to said stiffener (12).

8. A method of thinning a wafer (1) according to claim 7, **characterized in that** the stiffener (12) is applied by deposition.

9. A method of thinning a wafer (1) according to claim 8, **characterized in that** the stiffener (12) is a layer of silicon oxide.

10. A method of thinning a wafer (1) according to claim 7, **characterized in that** the stiffener (12) is a rigid plate.

11. A method of thinning a wafer (1) according to claim 10, **characterized in that** the rigid plate (12) is formed from monocrystalline or polycrystalline silicon, or from glass.

12. A method of thinning a wafer (1) according to claim 7, **characterized in that** the stiffener (12) is a flexible film.

13. A method of thinning a wafer (1) according to claim 7, **characterized in that** the stiffener (12) is an adhesive film.

14. A method of thinning a wafer (1) according to claim 7, **characterized in that** the stiffener (12) is a layer of wax.

15. A method of thinning a wafer (1) according to any preceding claim, **characterized in that** prior to the step of removing the rear portion (7), a stiffener (9) is applied to the front face (2) of said wafer (1) and the stiffener (9) is removed after having obtained the self-supported thin layer (6).

16. A method of thinning a wafer (1) according to any preceding claim, **characterized in that** said wafer (1) is formed from silicon.

17. A method of thinning a wafer (1) according to any one of claims 1 to 15, **characterized in that** the wafer (1) is a silicon on insulator wafer.

18. A method of thinning a wafer (1) according to any one of claims 1 to 15, **characterized in that** said wafer (1) is produced from a material selected from germanium, an alloy of silicon and germanium (Si-Ge), silicon carbide, gallium arsenide, indium phosphide, gallium nitride or aluminum nitride.

## Patentansprüche

1. Verfahren zur Dünnung eines Plättchens (1) aus Halbleitermaterial, das eine erste Seite (2), die sogenannte "Vorderseite", die zumindest ein elektronisches Bauelement und/oder einen elektronischen Schaltkreis (3) trägt - oder dazu bestimmt ist, es/ihn zu tragen, und eine zweite gegenüberliegende Seite (4), die sogenannte "Rückseite", aufweist, **dadurch gekennzeichnet, dass** es folgende Schritte umfasst:
a) Atomsorten von dessen Rückseite (4, 4') aus in das Innere des Plättchens (1) zu implantieren, so dass ein Versprödungsbereich (5) erhalten wird, der einen vorderen Bereich (6), der sich von der Vorderseite (2) zu diesem Versprödungsbereich (5) erstreckt, und einen hinteren Bereich (7), der vom Rest des Plättchens (1) gebildet wird, abgrenzt,
b) den hinteren Bereich (7) vom vorderen Bereich (6) zu lösen, um das Plättchen (1) abzudünnen,
c) die Schritte a) und b) auf der Rückseite (4") des vorderen Bereichs (6) so lange zu wiederholen, bis dieser die gewünschte Dicke aufweist, um eine selbsttragende Dünnschicht (6) darzustellen.

2. Verfahren zur Dünnung eines Plättchens (1) nach Anspruch 1, **dadurch gekennzeichnet, dass** das Plättchen (1), vor dem ersten Implantationsschritt a), durch ein an der Rückseite (4) vorgenommenes mechanisches und/oder chemisches Dünnungsverfahren abgedünnt wird.

3. Verfahren zur Dünnung eines Plättchens (1) nach Anspruch 1 oder 2, **dadurch gekennzeichnet, dass** vor dem ersten Implantationsschritt a) zumindest ein elektronisches Bauelement und/oder ein elektronischer Schaltkreis (3) auf der Vorderseite (2) des Plättchens (1) realisiert wird.

4. Verfahren zur Dünnung eines Plättchens (1) nach einem der vorstehenden Ansprüche, **dadurch gekennzeichnet, dass** der Schritt des Ablösens des hinteren Bereichs (7) durch Anwendung einer Wärmebehandlung und/oder äußerer mechanischer Belastungen erfolgt.

5. Verfahren zur Dünnung eines Plättchens (1) nach einem der vorstehenden Ansprüche, **dadurch gekennzeichnet, dass** der Schritt des Ablösens des hinteren Bereichs (7) durch Aufblasen eines Fluidstrahls erfolgt.

6. Verfahren zur Dünnung eines Plättchens (1) nach einem der vorstehenden Ansprüche, **dadurch gekennzeichnet, dass** der Schritt des Ablösens des hinteren Bereichs (7) durch Bürsten (11) erfolgt.

7. Verfahren zur Dünnung eines Plättchens (1) nach einem der vorstehenden Ansprüche, **dadurch gekennzeichnet, dass** der Schritt des Ablösens des hinteren Bereichs (7) durch Auftragen eines Verstärkungsmittels (12) auf die Rückseite (4, 4', 4") des Plättchens (1) und anschließende Anwendung einer Wärmebehandlung und/oder äußerer mechanischer Belastungen auf dieses Verstärkungsmittel (12) erfolgt.

8. Verfahren zur Dünnung eines Plättchens (1) nach Anspruch 7, **dadurch gekennzeichnet, dass** das Verstärkungsmittel (12) durch Abscheidung aufgetragen wird.

9. Verfahren zur Dünnung eines Plättchens (1) nach Anspruch 8, **dadurch gekennzeichnet, dass** das Verstärkungsmittel (12) eine Siliziumoxidschicht ist.

10. Verfahren zur Dünnung eines Plättchens (1) nach Anspruch 7, **dadurch gekennzeichnet, dass** das Verstärkungsmittel (12) eine feste Platte ist.

11. Verfahren zur Dünnung eines Plättchens (1) nach Anspruch 10, **dadurch gekennzeichnet, dass** die feste Platte (12) aus monokristallinem oder polykristallinem Silizium oder aus Glas besteht.

12. Verfahren zur Dünnung eines Plättchens (1) nach Anspruch 7, **dadurch gekennzeichnet, dass** das Verstärkungsmittel (12) eine elastische Folie ist.

13. Verfahren zur Dünnung eines Plättchens (1) nach Anspruch 7, **dadurch gekennzeichnet, dass** das Verstärkungsmittel (12) eine Klebefolie ist.

14. Verfahren zur Dünnung eines Plättchens (1) nach Anspruch 7, **dadurch gekennzeichnet, dass** das Verstärkungsmittel (12) eine Wachsschicht ist.

15. Verfahren zur Dünnung eines Plättchens (1) nach einem der vorstehenden Ansprüche, **dadurch gekennzeichnet, dass** vor dem Schritt des Ablösens des hinteren Bereichs (7), ein Verstärkungsmittel (9) auf der Vorderseite (2) des Plättchens (1) aufgetragen wird und **dadurch**, dass dieses Verstärkungsmittel (9) nach Erhalt der selbsttragenden Dünnschicht abgelöst wird (6).

16. Verfahren zur Dünnung eines Plättchens (1) nach einem der vorstehenden Ansprüche, **dadurch gekennzeichnet, dass** das Plättchen (1) aus Silizium besteht.

17. Verfahren zur Dünnung eines Plättchens (1) nach einem der Ansprüche 1 bis 15, **dadurch gekennzeichnet, dass** das Plättchen (1) ein "Silicon-on-Insulator"-Plättchen ist.

18. Verfahren zur Dünnung eines Plättchens (1) nach einem der Ansprüche 1 bis 15, **dadurch gekennzeichnet, dass** das Plättchen (1) aus einem Material realisiert wird, das gewählt ist aus Germanium, einer Silizium-Germanium-Legierung (Si-Ge), Siliziumkarbid, Galliumarsenid, Indiumphosphat, Gallium- oder Aluminiumnitrid.
